# EUROPEAN PATENT APPLICATION

(11) **EP 3 683 797 A1**
(43) Date of publication of application: **22.07.2020**
(21) Application number: 19152786.0
(22) Date of filing: 21.01.2019
(51) Int. Cl.: G11C 29/08, G11C 29/12, G11C 7/22, G01S 17/10, G01S 7/486, G01S 7/497, G11C 7/16, G11C 29/04, G11C 29/36, G11C 29/44

(54) **TOGGLED BUFFER MEMORY APPARATUS AND METHOD OF PROCESSING TIME SERIES DATA**

(71) Applicant: Melexis Technologies NV, 3980 Tessenderlo (BE)
(72) Inventor: Kyselov, Andrii, 03115 Kyiv (UA); Prévot, Samuel, 92140 Clamart (FR); Sacco, Vincenzo, San Jose 95128 , California (US); Norcross, Mitchell, Harvard, Massachusetts 01451 (US)
(74) Representative: Kay, Ross Marcel

(57) **Abstract**

A toggled buffer memory apparatus comprising a first memory block (134) arranged to support the first memory function over a first time frame and to toggle to support the second memory function over a second time frame. A second memory block (136) is also arranged to support the second memory function over the first time frame and to toggle to support the first memory function over the second time frame. A data input and a self-test block are respectively operably and selectively coupled to the first and second memory blocks. A controller is arranged to control toggling of the memory blocks (134, 136) which are each arranged to toggle between the first and second memory functions in respect of time frames subsequent to the second time frame. The self-test block is arranged to test the first memory block subsequent to the first memory block performing the first memory function and prior to toggling to perform the second memory function, and to test the second memory block subsequent to the second memory block performing the first memory function and prior to toggling to perform the second memory function.

## Description

The present invention relates to a toggled buffer memory apparatus of the type that, for example, comprises a self-test module. The present invention also relates to a method of processing time series data, for example digital time series data, the method being of the type that, for example, comprises a memory that self-tests.

In the field of enhanced vehicular safety systems, which sample signal bursts derived from, for example, signals reflected from objects in an environmental "scene" in the vicinity of a system that have been illuminated by a source of the system, record the samples and process the recorded samples, it is known to employ so-called double buffer Random Access Memory (RAM) to enhance processing performance, for example by facilitating substantially simultaneous writing of sample data to memory and processing of sample data in memory. It is also known to employ a so-called Built-In Self-Test (BIST) circuit with respect to such double buffer RAMs in order to detect faults in the RAM.

The design and operation of such BIST circuits should typically satisfy a number of commercial and performance criteria. For example, the BIST circuit should not consume excessive bandwidth of a Central Processor Unit (CPU), data buses, and/or interrupts. The BIST circuit should ideally be cost effective in terms of efficiency of die area usage by the BIST circuit, and should provide diagnostic coverage to an acceptable level. The results of the BIST circuit should also provide some detail of a failure for, inter alia, verification purposes.

Various methodologies for testing RAM are known. For example, it is known to execute a RAM self-test during runtime. However, such an approach consumes overall system bandwidth to an undesirable level. Self-testing can be performed at system start-up, but this leaves the system without diagnostic coverage during operation in respect of the application for which the RAM is intended. Parity bits can be stored by the RAM to test data integrity, but the storage of the additional bits requires additional die area to provide the additional storage capacity, making this approach cost prohibitive for some applications. Likewise designing redundant memory capacity into the RAM requires additional die area, which again can make this approach cost prohibitive for some applications.

Another testing technique is so-called non-destructive RAM diagnostic testing, where a RAM is tested block-by-block. However, this approach consumes excessive system bandwidth when executing. Similarly, so-called plausibility checking of data stored by a RAM consumes excessive system bandwidth when executing.

According to a first aspect of the present invention, there is provided a toggled buffer memory apparatus for simultaneously performing a first memory function and a second memory function, the apparatus comprising: a first memory block arranged to support the first memory function over a first time frame and to toggle to support the second memory function over a second time frame; a second memory block arranged to support the second memory function over the first time frame and to toggle to support the first memory function over the second time frame; a data input operably and selectively coupled to the first and second memory blocks; a self-test block operably coupled to the first and second memory blocks; and a controller arranged to control toggling of the first and second memory blocks; wherein the first and second memory blocks are each arranged to toggle between the first memory function and the second memory function in respect of time frames subsequent to the second time frame; the self-test block is arranged to test the first memory block subsequent to the first memory block performing the first memory function and prior to toggling to perform the second memory function; and the self-test block is arranged to test the second memory block subsequent to the second memory block performing the first memory function and prior to toggling to perform the second memory function.

The first memory function may comprise processing stored data and reading out the processed data; and the second memory function may comprise writing newly received data to memory prior to performing the first memory function.

The self-test block may be arranged to test the first or second memory block after data has been read out of the first or second memory block.

The first memory block may be arranged to perform one of the first and second memory functions in parallel with the second memory block performing another of the first and second memory functions.

The self-test block may be arranged to apply a fixed test pattern to the first memory block or the second memory block.

The fixed test pattern may be for testing a read function. The fixed test pattern may be for testing a write function.

The self-test block may be arranged to apply a sequence of test patterns to the first memory block or the second memory block.

The sequence of test patterns may be for testing a read function. The sequence of test patterns may be for testing a write function.

The self-test block may be arranged to complete testing of the first memory block or the second memory block before toggling memory functionality from the first memory function to the second memory function.

The self-test block may further comprise: a test controller operably coupled to a pattern generator the pattern generator may be operably coupled to the first memory block and the second memory block; and a results register may bre operably coupled to the controller, the first memory block and the second memory block.

According to a second aspect of the invention, there is provided a detector apparatus comprising the toggled buffer memory apparatus as set forth above in relation to the first aspect of the invention, the detector apparatus further comprising: a detector element operably coupled to the toggled buffer memory apparatus.

The detector element may be an optical detector element.

The apparatus may further comprise: an analogue-to-digital converter having an input thereof operably coupled to the detector element and an output thereof operably coupled to the data input of the toggled memory apparatus.

The apparatus may further comprise: a sample-and-hold block operably coupled to the detector element and the analogue-to-digital converter; wherein the sample-and-hold block may be arranged to generate time series data at a predetermined data acquisition frequency over a predetermined acquisition time period.

The self-test block may comprise a clock signal input; the clock signal input may be arranged to receive a clock signal of a same frequency as the predetermined data acquisition frequency.

The first memory function may be performed in less time than the predetermined acquisition time period.

According to a third aspect of the invention, there is provided a LIDAR apparatus comprising the toggled memory apparatus as set forth above in relation to the first aspect of the invention and/or the detector apparatus as set forth above in relation to the second aspect of the invention.

According to a fourth aspect of the invention, there is provided a method of processing time series data, the method comprising: a first memory block performing a first memory function over a first time frame while a second memory block performs a second memory function over the first time frame; the first memory block performing the second memory function over the second time frame while the second memory block performs the first memory function over the second time frame; toggling each of the first and second memory blocks between the first memory function and the second memory function in respect of time frames subsequent to the second time frame; a self-test block testing the first memory block subsequent to the first memory block performing the first memory function and prior to toggling to perform the second memory function; and the self-test block testing the second memory block subsequent to the second memory block performing the first memory function and prior to toggling to perform the second memory function.

It is thus possible to provide a toggled buffer memory apparatus and method of processing time series data that advantageously provides diagnostic coverage without consuming an undesirably large additional amount of die area and can provide diagnostic functionality during operation of the memory without consuming excessive system bandwidth. In this respect, and in contrast with parity or error correction coding protection, the apparatus and method can be implemented without adding redundant RAM bits to every sample location and, instead, only requires a relatively small logic circuit. Furthermore, the method, supported by the apparatus, does not add any additional time to the overall time interval used for writing sample data into a buffer while sample data is being processed in another buffer. In this respect, the time to process data in a buffer, read it out and then test the buffer is always less than the time to write data to a counterpart buffer, because the time to write the data to the counterpart buffer is constrained by the time it takes light pulses to propagate to objects in a scene and be reflected thereby in respect of a given emission-detection pair event. The apparatus and method also allow for a so-called "destructive" self-test algorithm to be implemented where existing data stored by a buffer under test can be overwritten. Additionally, the manner of reporting a fault status reduces processing overhead for both the memory apparatus and downstream processing apparatus co-operating with the memory apparatus, while permitting reporting of the fault status to the downstream processing apparatus within an acceptable time period in the context of the application of a system comprising the memory apparatus and the downstream processing apparatus.

At least one embodiment of the invention will now be described, by way of example only, with reference to the accompanying drawings, in which:
**Figure 1** is a schematic diagram of a LIDAR system comprising a toggled buffer memory apparatus constituting an embodiment of the invention;
**Figure 2** is a schematic diagram of a digital processing unit comprising the toggled buffer memory apparatus of Figure 1 in greater detail;
**Figures 3** is a schematic diagram of the toggled buffer memory apparatus of Figure 2 in greater detail;
**Figure 4** is an event sequence diagram of operation of the toggled buffer memory apparatus of Figure 3 constituting another embodiment of the invention; and
**Figure 5** is a flow diagram of a method of processing time sequence data constituting a further embodiment of the invention.

Throughout the following description, identical reference numerals will be used to identify like parts.

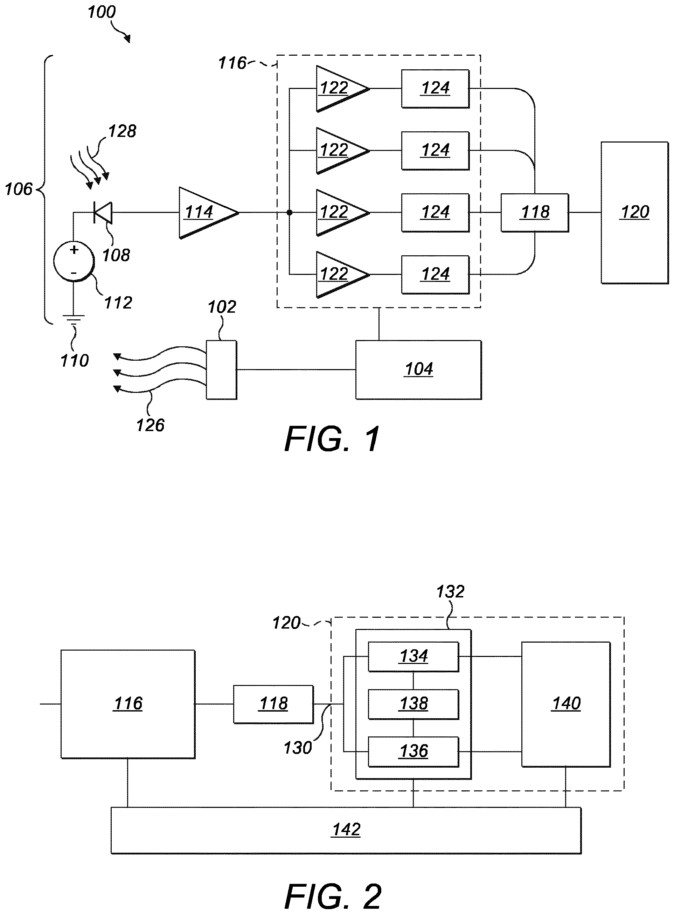

Referring to Figure 1, a pulsed-light detection and ranging apparatus, for example a LIDAR system 100 comprising a detector apparatus, comprises an illumination source 102, for example a pulsed light source, such as a pulsed laser, operably coupled to a synchronisation unit 104. The synchronisation unit 104 is operably coupled to an optical receive signal chain 106 supporting a receive "channel" constituting the detector apparatus. In this example, the LIDAR system 100 comprises sixteen receive channels with corresponding optical receive chains comprising sixteen optical detectors. However, for the sake of clarity and conciseness of description the following examples will be described in the context of a single optical receive signal chain 106. The skilled person will, however, appreciate that the LIDAR system 100 can typically comprise a greater number of optical receive signal chains, for example sixteen optical signal receive chains as suggested above. Indeed, it should also be appreciated that the detector elements can be arranged as a linear array or in any other suitable configuration, for example as a two-dimensional array.

The receive signal chain 106 comprises an optical sensor device 108, for example a photodiode device, having a cathode terminal operably coupled to ground potential 110 via a voltage source 112. An anode terminal of the optical sensor device 108 is operably coupled to an input of an amplifier circuit 114, for example a transconductance amplifier, an output of the amplifier circuit 114 being operably coupled to a sample-and-hold circuit 116. The sample-and-hold circuit 116 comprises a plurality of outputs operably coupled to a corresponding plurality of inputs of an Analogue-to-Digital Converter (ADC) 118. An output of the ADC 118 is operably coupled to a digital processing unit 120.

In this example, the sample-and-hold circuit 116 comprises a plurality of parallel sampling circuits, each sampling circuit 122 comprising an input operably coupled to the output of the amplifier circuit 114. Outputs of the parallel sampling circuits are respectively operably coupled to a plurality of storage circuits, each storage circuit 124 having an input operably coupled to the output of the associated counterpart sampling circuit 122 and an output operably coupled to a corresponding input of the ADC 118.

Turning to Figure 2, the digital processing unit 120 has an input 130 operably coupled to the output of the ADC 118. In this example, the digital processing unit 120 comprises a RAM unit 132, the RAM unit 132 comprising a first buffer 134 and a second buffer 136 constituting a first memory block and a second memory block, respectively. The first and second buffers 134, 136 are, in this example, 20-bit word organised without any byte/bit access and are operably coupled to a self-test module 138. It should be appreciated that other kinds of buffer architecture can be employed, Respective outputs of the first and second buffers 134, 136 are operably coupled to other downstream digital processing circuitry 140. The sample-and-hold circuit 116, the RAM unit 132 and the downstream digital processing circuitry 140 are operably coupled to a control unit 142 arranged to control, inter alia, timing in relation to processing of signals by the receive signal chain 106. In this regard, the self-test module 138 can be arranged to comprise a clock signal input for receiving a clock signal from the control unit 142, which can be at a same frequency as a predetermined data acquisition frequency used by the sample-and-hold circuit 116.

In many applications, the ADC 118 embraces more than one ADC, for example a pair of ADCs. In this regard, each ADC of the pair of ADCs is responsible for processing signals in respect of eight channels, thereby supporting all sixteen channels described above. However, for the sake of clarity and conciseness of description, a simplified implementation of the single ADC 118 being operably coupled to the digital processing unit 120 is described herein. The skilled person should appreciate that to support sixteen channels, for example, it is simply a matter of scaling the example described herein and, indeed, to support sixteen channels, a pair of buffers can be provided for each ADC.

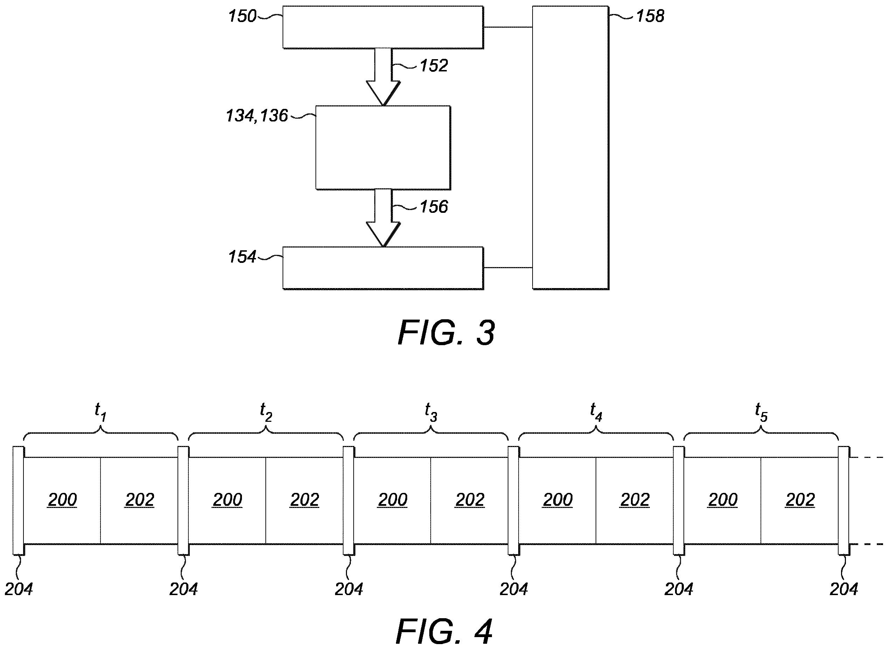

Referring to Figure 3, the self-test module or block 138 comprises a pattern generator 150 operably coupled to the first and second buffers 134, 136 via a data input bus 152. The first and second buffers 134, 136 are also operably coupled to a results register 154 via a data output bus 156. A self-test controller 158 is operably coupled to the pattern generator 150 and the results register 154. The self-test controller 158 comprises, in this example, two control ports, or bits: a first port is rising-edge sensitive and controls initiation of testing, and a second port is used to select the buffer to be tested. The self-test controller 158 is configured, in this example, to provide status and/or result output data. In this regard, the outputs comprise indications that: the test is in progress and/or the test has failed. Diagnostic outputs of the self-test controller 158 comprise: an indication of an address in respect of which a failure, for example an initial failure, has occurred, the incorrect data obtained, and/or an indication of where in a test algorithm, for example a march C- algorithm, the test has failed. The self-test module 138 is also configured to operate at a same or similar speed to the speed at which data is written to a buffer. The skilled person will, of course, appreciate that although a March C- algorithm is employed in the examples set forth herein, any suitable algorithm can be employed.

In operation, the LIDAR system 100, in a powered state, illuminates a "scene" by way of the optical illumination source 102 generating an optical pulse 126 that is emitted. Electromagnetic radiation emitted by the optical source 102 irradiates the scene and when a reflective object in the scene is encountered, some of the emitted light is reflected back to the LIDAR system 100. In the case of the channel described above, the optical signal receive chain 106 receives and processes the reflected light. The emission of the light is, in this example, repeated and, in response to each emission, a reflected optical signal is received. In this example, each emission-detection pair event has a duration spanning a time of emission of the optical signal until completion of receipt of a reflection of the emitted light back from a maximum object detection distance. Such illuminations are typically emitted in bursts, for example a predetermine number of emissions, and number of or "burst" of such emission-detection pair events occupy a "frame" of time. In order to support processing of the received optical signals, the LIDAR system 100 supports continuous processing and storage.

The received optical signal is translated into an electrical signal by the optical sensor 108, yielding a received signal in the electrical domain, which is amplified by the amplifier circuit 114. The amplified received electrical signal generated by the amplifier circuit 114 is, in this example, then sampled into a time series of samples, thereby generating a signal burst, which is stored in the sample-and-hold circuit 116 before being converted to the digital domain by the ADC 118, the signal burst corresponding in this example to the burst of emission-detection pair events. However, it should be appreciated that for some applications the sample-and-hold circuit 116 is optional and the analogue electrical signal output by the amplifier circuit 114 can be converted to the digital domain without first sampling and storing it. Nevertheless, in this and other embodiments, the use of the sample-and-hold circuit 116 can be of benefit where the sampling of the amplified received electrical signal generated by the amplifier circuit 114 is performed at a different frequency to the conversion to the digital domain by the ADC 118 and/or the sampling is performed at a different frequency to the frequency at which the digital data generated by the ADC 118 is written to the RAM unit 132.

Thereafter, the digital time series data output by the ADC 118 is then processed by the digital processing unit 120, some of the functionality of which will now be described. In this regard, the digital time series data for a given frame can comprise a large number, for example hundreds, of emitted and detected light pulses.

The frames of data output by the ADC 118 are loaded, in this example, alternately into the first buffer 134 and the second buffer 136. As such, while data is being loaded into one of the first and second buffers 134, 136, data already stored in the other of the first and second buffers 134, 136 is subjected to digital signal processing, i.e. substantially in parallel. The first and second buffers 134, 136 are therefore simultaneously performing a first memory function and a second memory function, the first memory function corresponding, in this example, to processing stored data followed by reading the processed data out of a buffer, and the second memory function corresponding, in this example, to writing data to a buffer.

In order to ensure integrity of data stored by the first and second buffers 134, 136, the self-test module 138 tests each of the first and second buffers 134, 136 following processing and onward communication of the data processed by the relevant buffer 134, 136 having its data processed. Referring to Figure 4, during a first time interval, t₁, the first buffer 134 is loaded with data of an (N-1)^{th} data frame, while data of an (N-2)^{th} data frame is processed in the second buffer 136. Then, during a second time interval, t₂, data of an N^{th} data frame is loaded into the second buffer 136 while the data loaded into the first buffer 134 in respect of the (N-1)^{th} data frame is processed. Subsequently, during a third time interval, t₃, data of an (N+1)^{th} data frame is loaded into the first buffer 134 while data of the N^{th} data frame previously loaded into the second buffer 136 is processed. Then, during a fourth time interval, t₄, data of an (N+2)^{th} data frame is loaded into the second buffer 136 while the data previously loaded into the first buffer 134 in respect of the (N+1)^{th} data frame is processed. Subsequently, during a fifth time interval, t₅, data of an (N+3)^{th} data frame is loaded into the first buffer 134 while data of the (N+2)^{th} data frame previously loaded into the second buffer 136 is processed. This pattern of alternate loading and processing of data with respect to the first and second buffers 134, 136 is repeated for as long as data is being output by the ADC 118 for processing.

In order to detect faulty operation of the RAM unit 132, in particular the first and second buffers 134, 136, processing of the time series data generated comprises testing of the first and second buffers 134, 136. In this regard, within a given time interval, tₙ, once processing of data stored in a given buffer has been completed, the data is then read from the given buffer for further processing. Once the data has been read out of the given buffer, the data stored therein no longer needs to be stored in the given buffer and a period of time remains of the given time interval, tₙ, during which the given buffer is unused. It can therefore be seen that the first memory function is performed in less time than the duration of a data frame, the duration being a predetermined acquisition time period. This period of time exists, alternately, in respect of the first and second buffers 134, 136 as a result of the alternating nature of writing/loading and processing of data stored in the first and second buffers 134, 136 described above. As such, following reading out of processed data from the given buffer, the period of time is used to test the given buffer. As such, it can be seen that the first and second buffer 134, 136 can be tested alternately whilst the RAM unit 132 is being used to store and support processing of time series data. In this example, the first and second buffers 134, 136 are respectively tested in accordance with a march C-algorithm. However, it should be appreciated that any suitable march algorithm, or indeed any other testing algorithm, can be employed if suitable for the application in question. The test bit pattern, for example a binary word, employed can be used to test a read function with respect to a buffer. Similarly, the test word employed can be used to test a write function with respect to a buffer. The test word can be fixed, for example hard-coded, or dynamically adaptable and can change throughout testing.

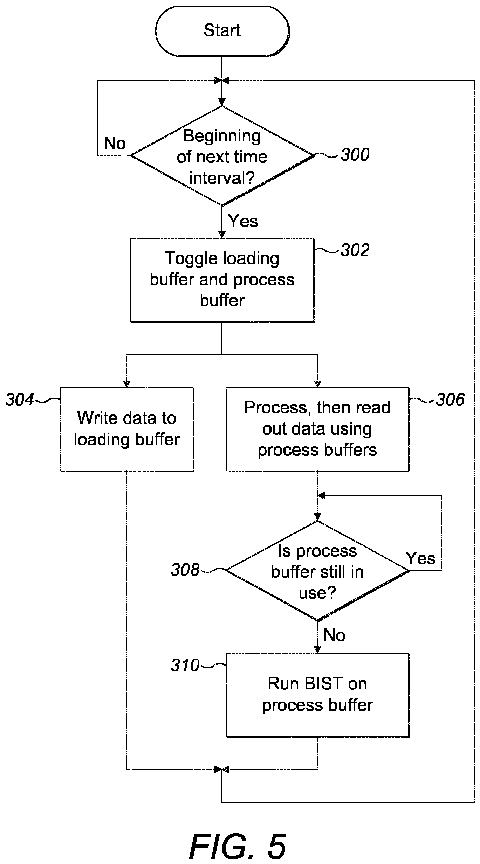

Referring to Figure 5, as well as Figure 4, the following example assumes that data has already started to flow through the LIDAR system 100 and the second buffer 136 contains data to be processed and the first buffer 134 requires data to be written to it for subsequent processing. In this regard, the control unit 142 determines (Step 300) whether a time interval has begun. In this example, if the first time interval, t₁, has not begun, the control unit 142 continues to wait. Once the first time interval, t₁, has begun, the control unit 142 toggles (Step 302) the roles of the first and second buffers 134, 136 as to which has data written to it and which will support processing and reading out of the processed data. In this example, the respective roles of the buffers 134, 136 are toggled (Step 302) so that the first buffer 134 is a "loading" buffer to which data is to be loaded, and the second buffer 136 is assigned as a "process" buffer to support processing and subsequent reading out of data already stored therein. Thereafter, data of an (N-1)^{th} data frame is written (Step 304) to the first buffer 134 and the second buffer 136 is responsible for supporting processing data (Step 306) already stored in it. As such, following processing of the data of the (N-2)^{th} data frame in the second buffer 136 during a first portion 200 of the first time interval, t₁, the processed data is then read out (Step 306) of the second buffer 136 during a second portion 202 of the first time interval, t₁, to leave the period of time 204 mentioned above. The self-test controller 158 waits (Step 308) until the second portion 202 of the first time interval, t₁, has expired, the second portion 202 of the first time interval, t₁, expiring once reading out of the processed data from the second buffer 136 has been completed. Then, during the period of time 204, the pattern generator 150, the results register 154, and the self-test controller 158 cooperate to test (Step 310) the second buffer 136. In this respect, the pattern generator 150 generates a series of test binary word patterns, for example a series of fixed binary words each of length that, for example, corresponds to the width of the second buffer 136. Each word pattern is, in this example, sequentially clocked through the second buffer 136. At the results register 154, words clocked out of the second buffer 136 are stored for analysis by the self-test controller 158 in order to determine whether each word clocked out of the second buffer 136 is an expected pattern or word indicative of the second buffer 136 operating correctly or whether one or more of the words clocked out of the second buffer 136 are incorrect, incorrect words being indicative of the second buffer 136 malfunctioning. If an incorrect word is detected by the self-test controller 158, the self-test controller 158 halts testing of the second buffer 136 and the incorrect data is stored in, for example, the results register 154. In this regard, the March C- algorithm yields, for example phase information, the failure result data and an address associated with the failed result data. In this example, when data is next read out of the RAM unit 132 to the downstream processing circuitry 140, any fault status is communicated to the downstream processing circuitry 140.

Assuming that the test concludes that the second buffer 136 is functioning correctly, at the end of the first time interval, t₁, which is detected (Step 300) by the control unit 142, the second time interval, t₂, begins and the second buffer 136 switches role (Step 302) to load (Step 304) data of the N^{th} data frame, while the first buffer 134 begins processing (Step 306) data of the (N-1)^{th} data frame written to the first buffer 134 during the first time interval, t₁. Following processing of the data of the (N-1)^{th} data frame during the first portion 200 of the second time interval, t₂, the processed data is then read out (Step 306) of the first buffer 134 during the second period of time 202 of the second time interval, t₂, to leave the period of time 204 mentioned above remaining. The self-test controller 158 then waits (Step 308) until the second portion 202 of the second time interval, t₂, has expired, the second portion 202 of the second time interval, t₂, expiring once reading out of the second processed data from the first buffer 134 has been completed. Then, during the period of time 204, the pattern generator 150, the results register 154, and the self-test controller 158 cooperate to test (Step 310) the first buffer 134. In this respect, the pattern generator 150 generates the series of binary test word patterns, for example the series of fixed binary words each of length that, for example, corresponds to the width of the first buffer 134. Each word pattern is, in this example, sequentially clocked through the first buffer 134. At the results register 154, the words clocked out of the first buffer 134 are stored for analysis by the self-test controller 158 in order to determine whether each word clocked out of the first buffer 134 is an expected pattern indicative of the first buffer 134 operating correctly or whether one or more of the words clocked out of the first buffer 134 are incorrect, incorrect words being indicative of the first buffer 134 malfunctioning. If an incorrect word is detected by the self-test controller 158, the self-test controller 158 halts testing of the second buffer 136 and the incorrect data is stored in, for example, the results register 154. In this regard, the March C- algorithm yields, for example phase information, the failure result data and an address associated with the failed result data. Again, when data is next read out of the RAM unit 132 to the downstream processing circuitry 140, any fault status is communicated to the downstream processing circuitry 140.

This pattern of switching the buffers 134, 136 between writing data to one buffer and processing/reading out data in respect of the other buffer is repeated as mentioned above for as long as data is available for processing, or processing is halted as a result of a faulty buffer being detected. Furthermore, it therefore follows that the process of testing the first and second buffers 134, 136 alternately is repeated with, and as, the role of supporting processing of the data switches between the first and second buffers 134, 136.

Once data has been read out of the buffers following processing, the data is further processed by the downstream digital processing circuitry 140 according to, in this example, functionality required of the LIDAR system 100, for example in order to detect reflected pulses from a signal burst and/or the time at which the pulses were received relative to a time of emission of an optical pulse. The downstream digital processing circuitry 140, in this example, also calculates a distance of a reflecting object responsible for the reflected pulses using the calculated time mentioned above. However, details of this processing are not central to an understanding of the inventive concepts described herein and so for the sake of conciseness and clarity of description will not be described in further detail herein.

The above toggled buffer memory apparatus and/or method of processing time series data is described above when the LIDAR system is used for the application for which it is intended. However, the skilled person should appreciate that the apparatus and method can also be used during production testing.

The skilled person should appreciate that the above-described implementations are merely examples of the various implementations that are conceivable within the scope of the appended claims. Indeed, although the above examples have been described in the context of a LIDAR system, the skilled person will appreciate that the principles set forth herein can be applied in relation to other applications to measurement of time-of-flight, and more generally to processing data using a memory having multiple buffers.

In the above examples, the pattern generator 150 is described as generating a series of fixed test words. However, the skilled person should appreciate that any suitable test bit patterns can be generated using any suitable technique, for example, the pattern generator 150 can be a pseudorandom pattern generator or any other suitable pattern generator.

## Claims

1. A toggled buffer memory apparatus for simultaneously performing a first memory function and a second memory function, the apparatus comprising:
a first memory block arranged to support the first memory function over a first time frame and to toggle to support the second memory function over a second time frame;
a second memory block arranged to support the second memory function over the first time frame and to toggle to support the first memory function over the second time frame;
a data input operably and selectively coupled to the first and second memory blocks;
a self-test block operably coupled to the first and second memory blocks; and
a controller arranged to control toggling of the first and second memory blocks; wherein
the first and second memory blocks are each arranged to toggle between the first memory function and the second memory function in respect of time frames subsequent to the second time frame;
the self-test block is arranged to test the first memory block subsequent to the first memory block performing the first memory function and prior to toggling to perform the second memory function; and
the self-test block is arranged to test the second memory block subsequent to the second memory block performing the first memory function and prior to toggling to perform the second memory function.

2. An apparatus as claimed in Claim 1, wherein
the first memory function comprises processing stored data and reading out the processed data; and
the second memory function comprises writing newly received data to memory prior to performing the first memory function.

3. An apparatus as claimed in Claim 2, wherein the self-test block is arranged to test the first or second memory block after data has been read out of the first or second memory block.

4. An apparatus as claimed in Claim 1 or Claim 2 or Claim 3, wherein the first memory block is arranged to perform one of the first and second memory functions in parallel with the second memory block performing another of the first and second memory functions.

5. An apparatus as claimed in any one of the preceding claims, wherein the self-test block is arranged to apply a fixed test pattern to the first memory block or the second memory block.

6. An apparatus as claimed in any one of the preceding claims, wherein the self-test block is arranged to apply a sequence of test patterns to the first memory block or the second memory block.

7. An apparatus as claimed in any one of the preceding claims, wherein the self-test block is arranged to complete testing of the first memory block or the second memory block before toggling memory functionality from the first memory function to the second memory function.

8. An apparatus as claimed in any one of the preceding claims, wherein the self-test block further comprises:
a test controller operably coupled to a pattern generator, the pattern generator being operably coupled to the first memory block and the second memory block; and
a results register operably coupled to the controller, the first memory block and the second memory block.

9. A detector apparatus comprising the toggled buffer memory apparatus as claimed in any one of the preceding claims, the detector apparatus further comprising:
a detector element operably coupled to the toggled buffer memory apparatus.

10. An apparatus as claimed in Claim 9, further comprising:
an analogue-to-digital converter having an input thereof operably coupled to the detector element and an output thereof operably coupled to the data input of the toggled memory apparatus.

11. An apparatus as claimed in Claim 10, further comprising:
a sample-and-hold block operably coupled to the detector element and the analogue-to-digital converter; wherein
the sample-and-hold block is arranged to generate time series data at a predetermined data acquisition frequency over a predetermined acquisition time period.

12. An apparatus as claimed in Claim 11, wherein the self-test block comprises a clock signal input, the clock signal input being arranged to receive a clock signal of a same frequency as the predetermined data acquisition frequency.

13. An apparatus as claimed in Claim 9, wherein the first memory function is performed in less time than the predetermined acquisition time period.

14. A LIDAR apparatus comprising the toggled memory apparatus as claimed in any one of Claims 1 to 8 and/or the detector apparatus as claimed in any one of Claims 9 to 13.

15. A method of processing time series data, the method comprising:
a first memory block performing a first memory function over a first time frame while a second memory block performs a second memory function over the first time frame;
the first memory block performing the second memory function over the second time frame while the second memory block performs the first memory function over the second time frame;
toggling each of the first and second memory blocks between the first memory function and the second memory function in respect of time frames subsequent to the second time frame;
a self-test block testing the first memory block subsequent to the first memory block performing the first memory function and prior to toggling to perform the second memory function; and
the self-test block testing the second memory block subsequent to the second memory block performing the first memory function and prior to toggling to perform the second memory function.
